# EUROPEAN PATENT APPLICATION

(11) **EP 4 620 615 A1**
(43) Date of publication of application: **24.09.2025**
(21) Application number: 23891415.4
(22) Date of filing: 07.11.2023
(51) Int. Cl.: B24B 9/00, B24B 49/04, B24B 49/10, H01L 21/304

(54) **POLISHING DEVICE**

(30) Priority: 14.11.2022 JP 2022181552
(71) Applicant: EBARA CORPORATION, Ota-ku, Tokyo 144-8510 (JP)
(72) Inventor: KODERA, Kenji, Tokyo 144-8510 (JP); HONG, Kuo-Wei, Tokyo 144-8510 (JP); OHASHI, Hirotaka, Tokyo 144-8510 (JP); YAMANOBE, Hokuto, Tokyo 144-8510 (JP); ISHIKAWA, Sho, Tokyo 144-8510 (JP)
(74) Representative: Pritzlaff, Stefanie Lydia
(86) International application number: PCT/JP2023/039986
(87) International publication number: WO 2024/106263

(57) **Abstract**

The present invention relates to a polishing apparatus. The polishing apparatus includes a sensor structure (100) configured to detect a polishing amount of a peripheral portion of a substrate (W). The sensor structure (100) includes a sensor head (102) having a contact surface (102a), and a displacement sensor (101) configured to detect the polishing amount of the peripheral portion of the substrate (W) based on a displacement of the sensor head (102).

## Description

### Technical Field

The present invention relates to a polishing apparatus.

### Background Art

In a process of manufacturing semiconductor devices, various films are formed on a peripheral portion of a wafer. These films can become a source of particles, so it is necessary to remove the films from the peripheral portion. Therefore, a polishing apparatus including an abrasive such as an abrasive tape is used to polish the peripheral portion of the wafer and remove the films from the peripheral portion. This polishing apparatus is configured to polish the peripheral portion by pressing the abrasive against the peripheral portion of the wafer while rotating the wafer around its axis.

### Citation List

### Patent Literature

Patent document 1: Japanese laid-open patent publication No. 2020-13918

### Summary of Invention

### Technical Problem

However, since the peripheral portion of the wafer is inclined and has a small area, it is generally difficult to accurately detect a polishing amount at the peripheral portion of the wafer. It is very important to detect the polishing amount with high accuracy since this contributes to accurately determining a polishing end point of the wafer.

Therefore, the present invention provides a polishing apparatus capable of detecting the polishing amount of the peripheral portion of a substrate such as a wafer with high accuracy.

### Solution to Problem

In an embodiment, there is provided a polishing apparatus comprising: a substrate stage configured to hold and rotate a substrate; a polishing head configured to press a polishing tool against a peripheral portion of the substrate; and a sensor structure configured to detect the polishing amount of the peripheral portion, and the sensor structure comprises: a sensor head having a contact surface configured to contact the peripheral portion; and a displacement sensor configured to detect the polishing amount of the peripheral portion by a displacement of the sensor head.

In an embodiment, the polishing apparatus comprises a control device configured to control operations of the polishing head and the sensor structure, and the control device is configured to cause the sensor structure to detect the polishing amount of an area that is the same as a polishing target area of the peripheral portion polished by the polishing head.

In an embodiment, the polishing apparatus comprises a sensor tilt mechanism configured to tilt the sensor structure, and the control device is configured to synchronize a tilt angle of the sensor structure with a tilt angle of the polishing head by operating the sensor tilt mechanism to bring the contact surface into contact with the peripheral portion.

In an embodiment, the control device is configured to: change the tilt angle of the sensor structure by operating the sensor tilt mechanism to obtain a reference value in a rotational direction of the substrate; and press the sensor structure against the peripheral portion at the same tilt angle as the tilt angle of the polishing head to determine a displacement amount from the reference value as the polishing amount polished by the polishing head.

In an embodiment, the control device is configured to store a target polishing amount for determining a polishing end point of the substrate, and the control device is configured to finish polishing of the peripheral portion when a determined polishing amount reaches the target polishing amount.

In an embodiment, the control device is configured to store a plurality of polishing angles for the peripheral portion, and the polishing amount at one of the polishing angles reaches the target polishing amount, wherein the control device is configured to change the tilt angle of the sensor structure along with the tilt angle of the polishing head to obtain the polishing amount at another of the polishing angles.

In an embodiment, the sensor structure comprises: a biasing member configured to bias the sensor head toward the peripheral portion; and a linear guide configured to restrict a movement direction of the sensor head to a linear direction.

In an embodiment, the contact surface has a width greater than a notch formed in the peripheral portion.

### Advantageous Effects of Invention

Since the polishing apparatus includes a sensor structure for detecting the polishing amount of the peripheral portion of the substrate, the polishing amount of the peripheral portion of the substrate can be detected with high accuracy.

### Brief Description of Drawings

[FIG. 1A] FIG. 1A is an enlarged cross-sectional view showing a peripheral portion of a substrate;
[FIG. 1B] FIG. 1B is an enlarged cross-sectional view showing a peripheral portion of a substrate;
[FIG. 2] FIG. 2 is a schematic view showing a polishing apparatus for polishing the peripheral portion of a wafer;
[FIG. 3] FIG. 3 is a view showing a head tilt mechanism that tilts a polishing head;
[FIG. 4] FIG. 4 is a view showing the polishing head (and the sensor structure) that is tilted up and down by the head tilt mechanism;
[FIG. 5] FIG. 5 is an enlarged view of the sensor structure;
[FIG. 6] FIG. 6 is a view showing a sensor tilt mechanism that tilts the sensor structure;
[FIG. 7] FIG. 7 is a flowchart showing a process for detecting a polishing amount of the peripheral portion of the wafer;
[FIG. 8] FIG. 8 is a view showing an example of a polishing angle of the wafer; and
[FIG. 9] FIG. 9 is a view showing changes in a reference value obtained while rotating the wafer.

### Description of Embodiments

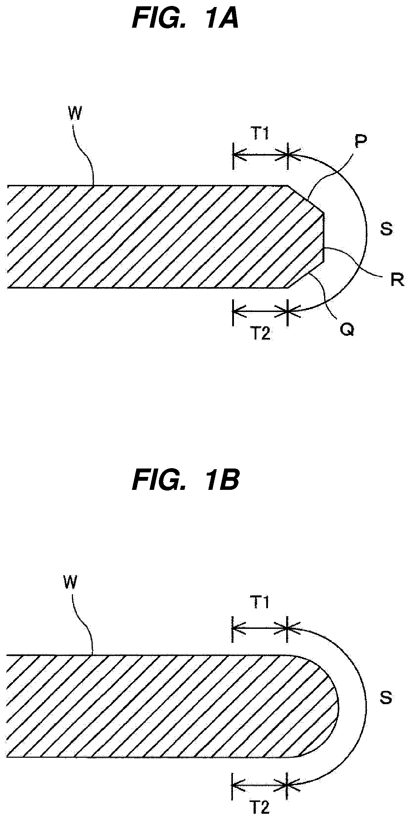

FIGS. 1A and 1B are enlarged cross-sectional views showing a peripheral portion of a substrate. More specifically, FIG. 1A is a cross-sectional view of a so-called straight type substrate, and FIG. 1B is a cross-sectional view of a so-called round type substrate. An example of the substrate is a wafer. The peripheral portion of the substrate is defined as an area including a bevel portion, a top edge portion, and a bottom edge portion.

In a wafer W in FIG. 1A, the bevel portion is an outermost peripheral surface (indicated by a symbol S) composed of an upper inclined portion (upper bevel portion) P, a lower inclined portion (lower bevel portion) Q, and a side portion (apex) R. In the wafer W of FIG. 1B, the bevel portion is a portion (indicated by the symbol S) that composes the outermost peripheral surface of the wafer W and has a curved cross section.

The top edge portion is an annular flat portion T1 located radially inward from the bevel portion S. The bottom edge portion is an annular flat portion T2 located on the opposite side to the top edge portion and radially inward from the bevel portion S. The top edge portion T1 and the bottom edge portion T2 are connected to the bevel portion S. The top edge portion T1 may include an area in which a device is formed.

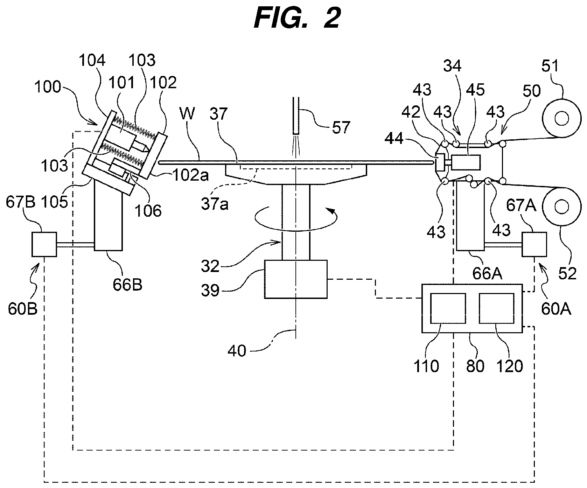

FIG. 2 is a schematic view showing a polishing apparatus for polishing the peripheral portion of the wafer. This polishing apparatus includes a substrate stage 32 that holds and rotates the wafer W, which is an example of a substrate, and a polishing head 34 that presses a polishing tape 42 as a polishing tool against the peripheral portion of the wafer W held by the substrate stage 32.

The substrate stage 32 includes a substrate holding surface 37 that holds the wafer W by vacuum suction, and a stage motor 39 that rotates the substrate holding surface 37. The wafer W is placed on the substrate holding surface 37 by a transfer device (not shown) with its back surface facing downward. A groove 37a is formed in the substrate holding surface 37, and the groove 37a communicates with a vacuum line 40. The vacuum line 40 is connected to a vacuum source (e.g., a vacuum pump) (not shown).

When a vacuum is formed in the groove 37a of the substrate holding surface 37 through the vacuum line 40, the wafer W is held on the substrate holding surface 37 by vacuum suction. In this state, the stage motor 39 rotates the substrate holding surface 37, rotating the wafer W around its axis. A diameter of the substrate holding surface 37 is smaller than a diameter of the wafer W, and a central area of the back surface of the wafer W is held by the substrate holding surface 37. The entire peripheral portion of the wafer W protrudes outward from the substrate holding surface 37.

The polishing head 34 is disposed adjacent to the substrate holding surface 37. More specifically, the polishing head 34 is disposed facing the peripheral portion of the wafer W on the substrate holding surface 37. The polishing head 34 includes a plurality of guide rollers 43 that support the polishing tape 42 as a polishing tool, a pressing member (e.g., a pressing pad) 44 that presses the polishing tape 42 against the peripheral portion of the wafer W, and an air cylinder 45 as an actuator that applies a pressing force to the pressing member 44.

The air cylinder 45 is coupled to the pressing member 44 and configured to move the pressing member 44 toward the substrate holding surface 37. The air cylinder 45 applies a pressing force to the pressing member 44, which causes the pressing member 44 to press the polishing tape 42 against the peripheral portion of the wafer W. Note that a grindstone may be used as the polishing tool instead of the polishing tape 42.

The polishing apparatus includes a head moving mechanism 60A that moves the polishing head 34 in a direction toward or away from the wafer W held on the substrate holding surface 37. The head moving mechanism 60A includes a coupling block 66A coupled to the polishing head 34, and a linear actuator 67A that moves the polishing head 34 via the coupling block 66A. The linear actuator 67A is, for example, a combination of a ball screw mechanism and a servo motor (not shown), and is configured to move the polishing head 34 toward (or away from) a position where the wafer W is polished.

The polishing apparatus includes a tape feed mechanism 50 incorporated in the polishing head 34. The tape feed mechanism 50 is configured to feed the polishing tape 42. One end of the polishing tape 42 is connected to a winding reel 51, and the other end is connected to a take-up reel 52. The tape feed mechanism 50 is configured to feed the polishing tape 42 from the winding reel 51 to the take-up reel 52 via the polishing head 34 at a predetermined speed. An example of the polishing tape 42 used includes a tape having abrasive grains fixed to its surface, or a tape made of hard nonwoven fabric.

The polishing apparatus includes a pure water supply nozzle 57 disposed above the wafer W held on the substrate holding surface 37. The pure water supply nozzle 57 is configured to supply pure water onto the wafer W. The pure water supply nozzle 57 is disposed above a center of the substrate holding surface 37. The pure water supplied onto an upper surface of the rotating wafer W spreads over the entire upper surface of the wafer W by centrifugal force, covering the entire upper surface of the wafer W. Therefore, the pure water can prevent particles from adhering to the upper surface of the wafer W during polishing of the peripheral portion of the wafer W.

As shown in FIG. 2, the polishing apparatus includes a sensor structure 100 for detecting a polishing amount of the peripheral portion of the wafer W. The sensor structure 100 includes a sensor head 102 having a contact surface 102a that contacts the peripheral portion of the wafer W, and a displacement sensor 101 that is connected to the sensor head 102 and detects the polishing amount of the peripheral portion of the wafer W by a displacement of the sensor head 102. An example of the displacement sensor 101 includes a detector such as a proximity sensor, a depth sensor, or a laser scale. The sensor head 102 is made of a high-hardness plate member (e.g., urethane rubber 90 degrees) coated with a coating having good sliding properties, or a high-hardness plate member to which a soft (e.g., resin) plate material that absorbs impacts caused by contact with the wafer is bonded.

The sensor structure 100 is configured to detect the polishing amount of the peripheral portion of the wafer W polished by the polishing head 34 by bringing the sensor head 102 into contact with the peripheral portion of the wafer W. A detailed structure of the sensor structure 100 will be described later.

The polishing apparatus includes a head moving mechanism 60B that moves the sensor structure 100 in a direction toward or away from the wafer W held on the substrate holding surface 37. The head moving mechanism 60B includes a coupling block 66B that is coupled to the sensor structure 100, and a linear actuator 67B that moves the sensor structure 100 via the coupling block 66B. The head moving mechanism 60B has a similar structure to the head moving mechanism 60A, and therefore a detailed description of the head moving mechanism 60B will be omitted.

As shown in FIG. 2, the polishing apparatus includes a control device 80 that controls operations of components of the polishing apparatus. The control device 80 is configured from a dedicated computer or a general-purpose computer. The control device 80 includes a storage device 110 that stores a program, and a processing device 120 that executes calculations according to the program.

In the embodiment shown in FIG. 2, the control device 80 is electrically connected to the polishing head 34, the sensor structure 100, the head moving mechanisms 60A and 60B, and the stage motor 39, and is configured to control the operations of the polishing head 34, the sensor structure 100, the head moving mechanisms 60A and 60B, and the stage motor 39. The control device 80 may also control the operation of the pure water supply nozzle 57.

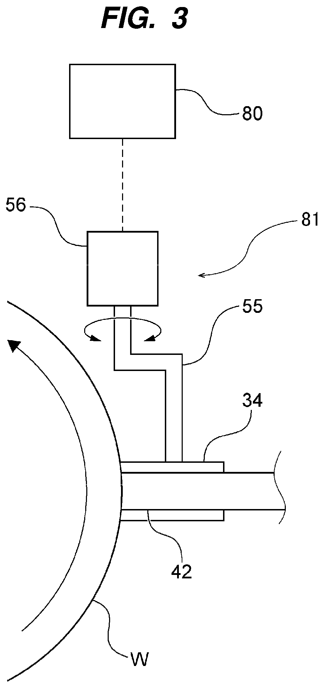

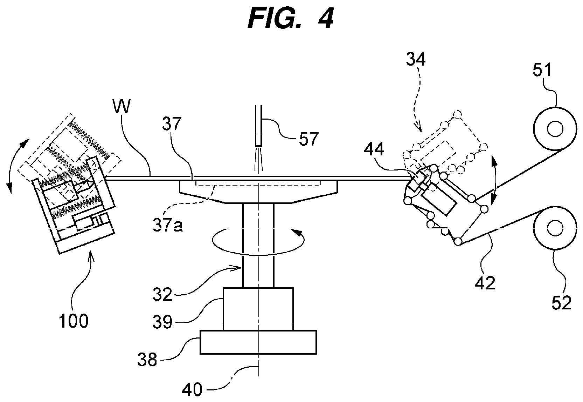

FIG. 3 is a view showing a head tilt mechanism that tilts the polishing head. FIG. 4 is a view showing the polishing head (and the sensor structure) that is tilted up and down by the head tilt mechanism. As shown in FIG. 3, the polishing apparatus includes a head tilt mechanism 81 that tilts the polishing head 34 with respect to the surface of the wafer W on the substrate stage 32. The head tilt mechanism 81 includes a crank arm 55 that holds the polishing head 34, and a servo motor 56 coupled to the crank arm 55.

One end of the crank arm 55 is fixed to the polishing head 34, and the other end of the crank arm 55 is coupled to the servo motor 56. The crank arm 55 is generally parallel to the substrate holding surface 37. The control device 80 is electrically connected to the servo motor 56. When the servo motor 56 alternately rotates the crank arm 55 clockwise and counterclockwise by a predetermined angle in accordance with a command from the control device 80, the entire polishing head 34 tilts up and down with respect to the surface of the wafer W (see the arrows in FIG. 4). In this manner, the control device 80 can control an operation of the head tilt mechanism 81.

The peripheral portion of the wafer W is polished as follows. The wafer W held on the substrate holding surface 37 is rotated around its axis by the stage motor 39. Pure water is supplied from a liquid supply nozzle 57 onto the upper surface of the rotating wafer W. The polishing head 34 tilts up and down while pressing the polishing tape 42 against the peripheral portion of the wafer W. In the presence of the pure water, the polishing tape 42 comes into sliding contact with the peripheral portion of the rotating wafer W, thereby polishing the peripheral portion.

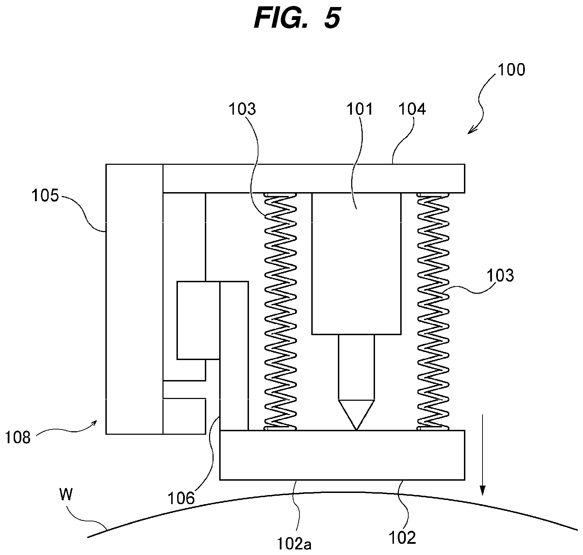

FIG. 5 is an enlarged view of the sensor structure. As shown in FIG. 5, the sensor structure 100 includes the displacement sensor 101, the sensor head 102, a biasing member 103 that biases the sensor head 102 toward the peripheral portion of the wafer W, a base plate 104 to which the displacement sensor 101 is fixed, and a linear guide 108 that restricts a movement direction of the sensor head 102 to a linear direction.

The biasing member 103 is fixed to the sensor head 102 and the base plate 104. In this embodiment, the biasing member 103 is a spring, but in one embodiment, it may be an air cylinder that biases the sensor head 102. The biasing member 103 presses the sensor head 102 against the peripheral portion of the wafer W with a biasing force that does not cause the sensor head 102, which comes into contact with the peripheral portion of the rotating wafer W, to bounce back with force and does not cause the wafer W to bend more than necessary.

The linear guide 108 includes a guide rail 105 fixed to the base plate 104, and a slider 106 fixed to the sensor head 102 and attached to the guide rail 105. When the slider 106 moves along the guide rail 105, the sensor head 102 fixed to the slider 106 moves in a linear direction.

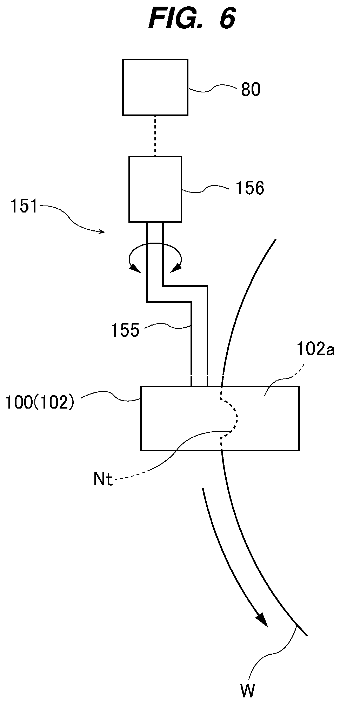

FIG. 6 is a view showing a sensor tilt mechanism that tilts the sensor structure. As shown in FIG. 6, the polishing apparatus includes a sensor tilt mechanism 151 that tilts the sensor structure 100 with respect to the surface of the wafer W on the substrate stage 32. The sensor tilt mechanism 151 includes a crank arm 155 that holds the sensor structure 100, and a servo motor 156 coupled to the crank arm 155.

One end of the crank arm 155 is fixed to the sensor structure 100, and the other end of the crank arm 155 is coupled to the servo motor 156. The crank arm 155 is generally parallel to the substrate holding surface 37. The control device 80 is electrically connected to the servo motor 156. When the servo motor 156 alternately rotates the crank arm 155 clockwise and counterclockwise by a predetermined angle in accordance with a command from the control device 80, the entire sensor structure 100 tilts up and down with respect to the surface of the wafer W (see the arrows in FIG. 4). In this manner, the control device 80 can control an operation of the sensor tilt mechanism 151.

In this embodiment, the head tilt mechanism 81 and the sensor tilt mechanism 151 have the same structure, but in one embodiment, the head tilt mechanism 81 and the sensor tilt mechanism 151 may have different structures.

As shown in FIG. 6, the contact surface 102a of the sensor head 102 has a width larger than a notch Nt formed on the peripheral portion of the wafer W. Therefore, even if the sensor head 102 is pressed against the peripheral portion of the wafer W while the wafer W is rotating, the sensor head 102 will not enter the notch Nt, and damage to the notch Nt (and/or the sensor head 102) can be prevented.

Since a rotational force acts on the rotating wafer W, if the displacement sensor 101 is brought into direct contact with the peripheral portion of the wafer W, the displacement sensor 101 may be affected by the rotational force of the wafer W and may not be able to accurately detect the polishing amount of the peripheral portion of the wafer W. In this embodiment, the sensor structure 100 has a structure that brings the sensor head 102 into contact with the peripheral portion of the wafer W, so that the displacement sensor 101 can accurately detect the polishing amount of the peripheral portion of the wafer W via the sensor head 102.

Furthermore, by providing the sensor head 102, it is possible to prevent the displacement sensor 101 from directly contacting the peripheral portion of the wafer W. As a result, it is possible to prevent damage to the displacement sensor 101 caused by contact with the notch Nt.

The control device 80 is configured to cause the sensor structure 100 to detect the polishing amount of an area (polishing amount detection area) that is the same as an area to be polished on the peripheral portion of the wafer W polished by the polishing head 34. The control device 80 is configured to synchronize the operations of the head tilt mechanism 81 and the sensor tilt mechanism 151. Thus, the control device 80 synchronizes a tilt angle of the sensor structure 100 with a tilt angle of the polishing head 34 by the operation of the sensor tilt mechanism 151, and brings the contact surface 102a of the sensor head 102 into contact with the peripheral portion of the wafer W being polished.

With this configuration, the control device 80 can match the polishing amount detection area of the sensor structure 100 with a polishing target area of the polishing head 34, and as a result, the sensor structure 100 can detect in real time the polishing amount of the peripheral portion of the wafer W. The control device 80 controls the operations of the polishing head 34 and the sensor structure 100 based on the polishing amount sent from the sensor structure 100.

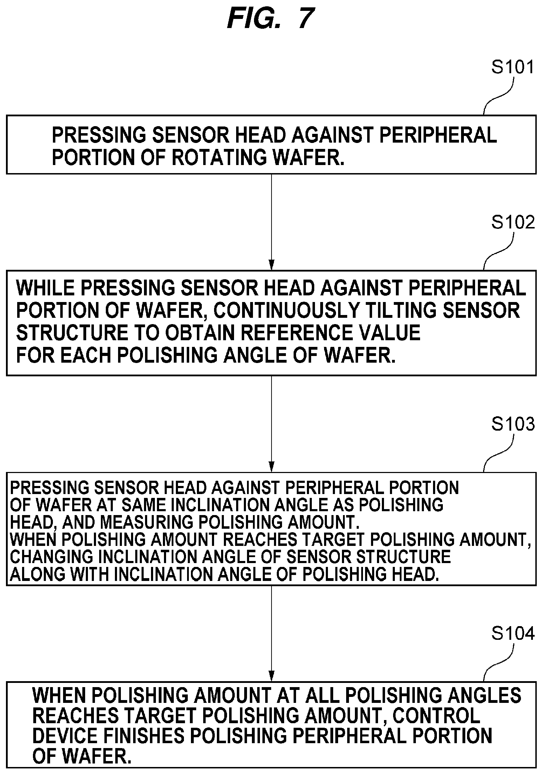

FIG. 7 is a flowchart showing a process for detecting the polishing amount of the peripheral portion of the wafer. First, the control device 80 rotates the wafer W held on the substrate holding surface 37 of the substrate stage 32, and presses the sensor head 102 of the sensor structure 100 against the peripheral portion of the rotating wafer W (see step S101 in FIG. 7).

Thereafter, the control device 80 continuously changes an inclination angle of the sensor structure 100 while pressing the sensor head 102 against the peripheral portion of the wafer W, and obtains a reference value for each polishing angle of the wafer W (see step S102 in FIG. 7). The control device 80 stores an initial state of the peripheral portion of the wafer W by obtaining the reference value.

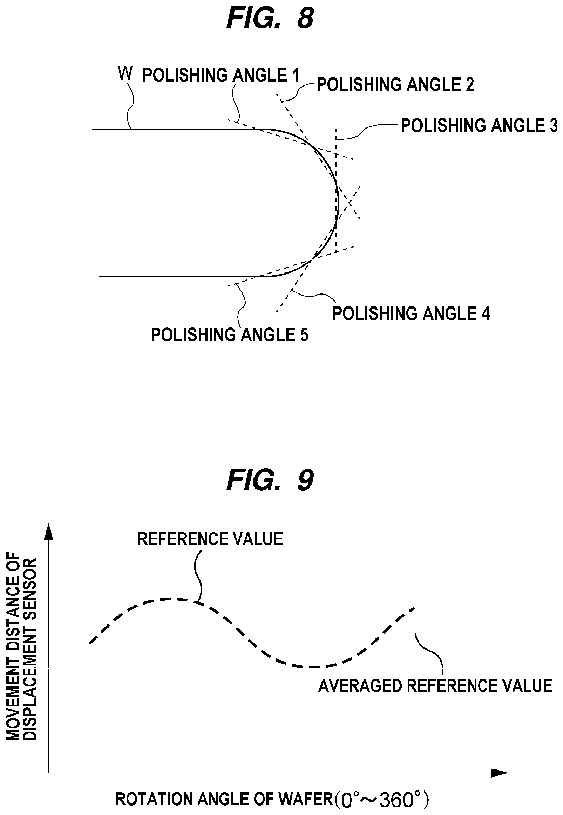

FIG. 8 is a view showing an example of the polishing angle of the wafer. In the embodiment shown in FIG. 8, five polishing angles (polishing angle 1 to polishing angle 5) are provided along the peripheral portion of the wafer W, and the storage device 110 of the control device 80 stores these five polishing angles. In one embodiment, at least one polishing angle may be provided.

FIG. 9 is a view showing changes in the reference value obtained while rotating the wafer. In FIG. 9, a horizontal axis indicates a rotation angle (0 degrees to 360 degrees) of the wafer W, and a vertical axis indicates a movement distance of the displacement sensor 101. As shown in FIG. 9, while rotating the wafer W, the control device 80 presses the sensor head 102 against the peripheral portion of the wafer W to obtain the reference value for each rotation angle of the wafer W.

By repeating this process, the reference values for all the polishing angles are obtained. For example, in the case where five polishing angles are provided, the control device 80 obtains the reference values for each rotation angle of the wafer W at the polishing angles 1 to 5.

For example, the control device 80 operates the sensor tilt mechanism 151 to determine the tilt angle of the sensor structure 100 to the polishing angle 1 (see FIG. 8), and while pressing the sensor head 102 against the peripheral portion of the rotating wafer W, causes the displacement sensor 101 to detect the reference value of the peripheral portion of the wafer W at the polishing angle 1.

Next, the control device 80 operates the sensor tilt mechanism 151 to determine the tilt angle of the sensor structure 100 to the polishing angle 2 (see FIG. 8), and while pressing the sensor head 102 against the peripheral portion of the rotating wafer W, causes the displacement sensor 101 to detect the reference value of the peripheral portion of the wafer W at the polishing angle 2. In this manner, the control device 80 causes the displacement sensor 101 to detect the reference value of the peripheral portion of the wafer W at all of the polishing angles stored in the storage device 110.

In the embodiment shown in FIG. 9, the movement distance of the displacement sensor 101 changes continuously, and the reference value for the rotation angle of the wafer W also changes continuously. In such a case, the control device 80 may average the continuously changing reference value.

After step S102 in FIG. 7, the control device 80 presses the sensor structure 100 against the peripheral portion of the wafer W at the same inclination angle as the inclination angle of the polishing head 34. At this time, since the polishing head 34 is continuously polishing the peripheral portion of the wafer W, the sensor head 102 is displaced toward a center of the wafer W by the biasing member 103.

The displacement sensor 101 detects a displacement amount from the reference value. Since the displacement amount detected by the displacement sensor 101 corresponds to the polishing amount polished by the polishing head 34, the control device 80 determines the displacement amount detected by the displacement sensor 101 to be the polishing amount polished by the polishing head 34.

As shown in step S103 in FIG. 7, the control device 80 presses the sensor head 102 against the peripheral portion of the wafer W at the same inclination angle as the inclination angle of the polishing head 34, and determines (measures) the polishing amount in real time. The storage device 110 of the control device 80 stores a target polishing amount for determining a polishing end point of the wafer W. Therefore, when the determined polishing amount reaches the target polishing amount, the control device 80 changes the inclination angle of the sensor structure 100 together with the inclination angle of the polishing head 34, and changes the polishing angle to be polished from the polishing angle already used (e.g., polishing angle 1) to a new polishing angle (e.g., polishing angle 2).

As shown in step S104 in FIG. 7, when the polishing amount at all polishing angles reach the target polishing amount, the control device 80 finishes polishing of the peripheral portion of the wafer W. In one embodiment, in a case where one polishing angle is provided, the control device 80 finishes polishing of the peripheral portion of the wafer W when the determined polishing amount reaches the target polishing amount.

Since the peripheral portion of the wafer W is inclined and has a small area, it is generally difficult to accurately detect the polishing amount of the peripheral portion of the wafer W for each polishing angle. According to this embodiment, the compact sensor structure 100 provided separately from the polishing head 34 can contact the peripheral portion of the wafer W at the same inclination angle as the inclination angle of the polishing head 34. Therefore, the sensor structure 100 can detect the polishing amount of the peripheral portion of the wafer W during polishing in real time for each polishing angle.

The polishing head 34 starts polishing the peripheral portion of the wafer W from the moment it comes into contact with the peripheral portion of the wafer W. Therefore, even if a sensor (i.e., a sensor equivalent to the displacement sensor 101) is provided in the polishing head 34, the sensor cannot detect zero polishing amount (polishing amount at the start of polishing). As a result, the described sensor may not be able to detect a desired polishing amount.

In this embodiment, the sensor structure 100 is provided separately from the polishing head 34, and therefore can contact the peripheral portion of the wafer W simultaneously with the polishing head 34. Therefore, the displacement sensor 101 can detect zero polishing amount, and as a result, can reliably detect the desired polishing amount.

The substrate stage 32 may hold the wafer W at an inclination due to an installation error. In this case, when the wafer W held by the substrate stage 32 rotates, the surface of the wafer W is inclined with respect to the horizontal direction. In this state, even if the polishing head 34 is brought into contact with the peripheral portion of the wafer W, the polishing head 34 cannot stably polish the peripheral portion of the wafer W. Furthermore, if the center of the wafer W and the center of rotation of the substrate stage 32 are misaligned, the wafer W rotates eccentrically, and the polishing head 34 cannot stably polish the peripheral portion of the wafer W.

In this embodiment, the sensor structure 100 has a contact-type sensor structure in which the sensor head 102 is brought into contact with the peripheral portion of the wafer W. Therefore, the control device 80 can recognize a positional state of the wafer W during polishing (e.g., the inclination of the wafer W, the eccentric rotation of the wafer W) based on the displacement amount detected by the displacement sensor 101.

By bringing the sensor head 102 into contact (surface contact) with the peripheral portion of the wafer W, even if the wafer W is rotating at an angle relative to the horizontal direction, the sensor head 102 can continue to be in contact with the peripheral portion of the wafer W without moving away from the peripheral portion of the wafer W. As a result, the control device 80 can measure the polishing amount while minimizing the effect of the positional state of the wafer W.

The above-described embodiments have been described for the purpose of enabling a person having ordinary skill in the art to practice the present invention. Various modifications of the above-described embodiments are naturally possible for a person skilled in the art, and the technical idea of the present invention can be applied to other embodiments. Therefore, the present invention is not limited to the described embodiments, but is to be interpreted in the broadest scope according to the technical idea defined by the claims.

### Industrial Applicability

The present invention is applicable to a polishing apparatus.

### Reference Signs List

- 32: substrate stage
- 34: polishing head
- 37: substrate holding surface
- 37a: groove
- 39: stage motor
- 40: vacuum line
- 42: polishing tape
- 43: guide roller
- 44: pressing member
- 45: air cylinder
- 50: tape feed mechanism
- 51: winding reel
- 52: take-up reel
- 55: crank arm
- 56: servo motor
- 57: pure water supply nozzle
- 60A, 60B: head moving mechanism
- 66A, 66B: coupling block
- 67A, 67B: linear actuator
- 80: control device
- 81: head tilt mechanism
- 100: sensor structure
- 101: displacement sensor
- 102: sensor head
- 102a: contact surface
- 103: biasing member
- 104: base plate
- 105: guide rail
- 106: slider
- 108: linear guide
- 110: storage device
- 120: processing device
- 151: sensor tilt mechanism
- 155: crank arm
- 156: servo motor

## Claims

1. A polishing apparatus comprising:
a substrate stage configured to hold and rotate a substrate;
a polishing head configured to press a polishing tool against a peripheral portion of the substrate; and
a sensor structure configured to detect a polishing amount of the peripheral portion, and
wherein the sensor structure comprises:
a sensor head having a contact surface configured to contact the peripheral portion; and
a displacement sensor configured to detect the polishing amount of the peripheral portion by a displacement of the sensor head.

2. The polishing apparatus according to claim 1,
wherein the polishing apparatus comprises a control device configured to control operations of the polishing head and the sensor structure, and
wherein the control device is configured to cause the sensor structure to detect the polishing amount of an area that is the same as a polishing target area of the peripheral portion polished by the polishing head.

3. The polishing apparatus according to claim 2,
wherein the polishing apparatus comprises a sensor tilt mechanism configured to tilt the sensor structure, and
wherein the control device is configured to synchronize a tilt angle of the sensor structure with a tilt angle of the polishing head by operating the sensor tilt mechanism to bring the contact surface into contact with the peripheral portion.

4. The polishing apparatus according to claim 3,
wherein the control device is configured to:
change the tilt angle of the sensor structure by operating the sensor tilt mechanism to obtain a reference value in a rotational direction of the substrate; and
press the sensor structure against the peripheral portion at the same tilt angle as the tilt angle of the polishing head to determine a displacement amount from the reference value as the polishing amount polished by the polishing head.

5. The polishing apparatus according to claim 4,
wherein the control device is configured to store a target polishing amount for determining a polishing end point of the substrate, and
wherein the control device is configured to finish polishing of the peripheral portion when a determined polishing amount reaches the target polishing amount.

6. The polishing apparatus according to claim 5,
wherein the control device is configured to store a plurality of polishing angles for the peripheral portion, and
when the polishing amount at one of the polishing angles reaches the target polishing amount, wherein the control device is configured to change the tilt angle of the sensor structure along with the tilt angle of the polishing head to obtain the polishing amount at another of the polishing angles.

7. The polishing apparatus according to claim 1,
wherein the sensor structure comprises:
a biasing member configured to bias the sensor head toward the peripheral portion; and
a linear guide configured to restrict a movement direction of the sensor head to a linear direction.

8. The polishing apparatus according to claim 1,
wherein the contact surface has a width greater than a notch formed in the peripheral portion.
